# EUROPEAN PATENT APPLICATION

(11) **EP 3 817 518 A1**
(43) Date of publication of application: **05.05.2021**
(21) Application number: 19206447.5
(22) Date of filing: 31.10.2019
(51) Int. Cl.: H05K 1/02, H05K 3/34

(54) **A METHOD FOR MANUFACTURING A CIRCUIT BOARD, AND ASSOCIATED CIRCUIT BOARD**

(71) Applicant: Aptiv Technologies Limited, St. Michael (BB)
(72) Inventor: GUILLANTON, Erwan, 28230 Epernon (FR); PEROT, Aymeric, 28000 Chartres (FR)
(74) Representative: Vigand, Philippe

(57) **Abstract**

The circuit including an electronic component (1), the method comprises the steps of
- placing (S4) the electronic component (1) onto a first surface (4) of a board (2),
- mounting (S6, S7) an elastic component (6) on the board (2), said elastic component (6) having the function of pushing the electronic component (1) away from the first surface (4) of the board (2) when a temperature of said electronic component (1) exceeds a predetermined threshold,
- soldering (S5) the electronic component (1) onto the first surface (4) of the board (2).

The step of mounting the elastic component (6) is performed after the step of soldering the electronic component (1).

## Description

### TECHNICAL FIELD

The present disclosure relates to the field of manufacturing a circuit board, manufactured circuit boards and electronic devices incorporating such circuit boards.

### BACKGROUND

Power semiconductor devices such as Metal-Oxide-Semi-conductor Field-Effect Transistor (MOSFET) devices are more and more used as electronic switches to replace mechanical switches as their lifetime is longer. In order to switch a high current I (for example several hundreds amps), a bank of N power MOSFETs connected in parallel is generally used, each power MOSFET switching a reduced current approximatively equal to I/N. However, under certain conditions, for example when a short overcurrent is applied, one of the MOSFETs may fail and then stay in a short-circuit state. After the failure, when the bank of MOSFETs is switched off, all the high-current I passes through the failed MOSFET that is stuck closed. This situation results in a heating of the failed MOSFET, which may lead to a thermal incident, such as a thermal ignition, and cause a fire.

In order to address this problem and avoid such a thermal ignition, document US 8,816,390 discloses a circuit board, a semiconductor package and a component made of a thermally deformable material, both mounted on a first surface of the circuit board. The thermally deformable component is mounted within a cavity provided in the first surface and sandwiched between the semiconductor package and the first surface of the circuit board. When the temperature of the assembly exceeds a first temperature, due to an overheating of the semiconductor package, the thermally deformable material is activated and pushes the semiconductor package away from the circuit board, which results in interrupting the passage of current. Consequently, the temperature of the assembly decreases.

However, the manufacture of the circuit board disclosed in US 8,816,390 may be difficult to implement on an industrial scale. Indeed, during soldering of the semiconductor package onto the circuit board, the thermally deformable material should not be activated and/or push the semiconductor package away from the circuit board. It may be necessary to maintain the semiconductor package in position onto the board, which may cause problems during a wave soldering.

There is a need to improve the situation. More precisely, there is a need to facilitate the method for manufacturing a circuit board having a component for pushing away an electronic component, mounted on the circuit board, such as a semiconductor component, when a temperature of this electronic component increases too much.

### SUMMARY

The present disclosure concerns a method for manufacturing a circuit board, said circuit including an electronic component, comprising the steps of
- placing the electronic component onto a first surface of a board,
- mounting an elastic component on the board, said elastic component having the function of pushing the electronic component away from the first surface of the circuit board when a temperature of said electronic component exceeds a predetermined threshold,
- soldering the electronic component onto the first surface of the circuit board, characterized in that
   the step of mounting the elastic component is performed after the step of soldering.

As the elastic component is mounted on the circuit board after soldering the electronic component, any drawback of an undesirable release of the elastic component is avoided during soldering.

Advantageously, the elastic component is disposed within a hole provided through the board. The use of a through hole to mount the elastic component allows for easy insertion of the elastic component within the hole after soldering from the side of the board that is opposite to the first surface of the board on which the electronic component is mounted.

Advantageously, the method comprises a step of mounting a compressing component on a second surface of the board, opposite to the first surface, such that the elastic component is sandwiched between the electronic component and the compressing component. For example, a heat sink can be mounted onto the second surface of the board and used to compress the elastic component.

The elastic component may be one of the components of the group including a component made of silicone, a metallic leaf spring and a coil spring. Any other shape of elastic component may be used.

Advantageously, the electronic component is soldered on the board by wave soldering. Wave soldering is widely used in the manufacture of printed circuit boards, on an industrial scale. The method of the present disclosure can be easily used on an industrial scale.

Advantageously, the predetermined temperature threshold corresponds to the melting point of a solder paste used to solder the electronic component to the board. When the electronic component has failed and is then stuck in a short circuit condition, its temperature may arise due to a high current flowing through it. When the temperature of the electronic component reaches or exceeds the melting point of the solder paste, the electronic component is no longer strongly stuck onto the board. As a result, the elastic component releases and pushes the electronic component away from the first surface of the board, which lead to a disconnection of the electronic component from the circuit. Consequently, the current is interrupted and the temperature of the electronic component decreases.

The present disclosure also concerns a circuit board comprising an electronic component soldered onto a first surface of a board and an elastic component, mounted on said board, for pushing the electronic component away from the first surface of the board when a temperature of said electronic component exceeds a predetermined temperature threshold, characterized in that the elastic component is disposed within a hole provided through the board and compressed by being sandwiched between the electronic component and a compressing component mounted on a second surface of the board, opposite to the first surface.

Advantageously, a heat sink is mounted onto the second surface of the board and compresses the elastic component.

Advantageously, the elastic component is one of the components of the group including a component made of silicone, a metallic leaf spring and a coil spring.

The electronic component may be a power transistor.

Advantageously, the electronic component is soldered to the board with a solder paste, and the predetermined temperature threshold corresponds to the melting point of the solder paste.

The circuit may comprise a plurality of N electronic components soldered onto the first surface of the board and N elastic components may be respectively mounted within N holes provided through the board and put in a compressed state.

The present disclosure also concerns an electronic device incorporating the circuit board previously defined.

### BRIEF DESCRIPTION OF THE DRAWINGS

Other features, purposes and advantages of the disclosure will become more explicit by means of reading the detailed statement of the non-restrictive embodiments made with reference to the accompanying drawings.
Figure 1 shows a circuit board, with an elastic component in a compressed condition, according to a first exemplary embodiment;
Figure 2 shows the circuit board of figure 1, with the elastic component in a released condition;
Figure 3 shows a more detailed view of the elastic component of figure 2 (in a released condition);
Figure 4 shows a circuit board, with an elastic component in a compressed condition, according to a second exemplary embodiment;
Figure 5 shows the elastic component of figure 4;
Figure 6 is an organigram of a method for manufacturing a circuit board, such as the circuit board of figure 1 or 4, according to an exemplary embodiment.

### DETAILED DESCRIPTION

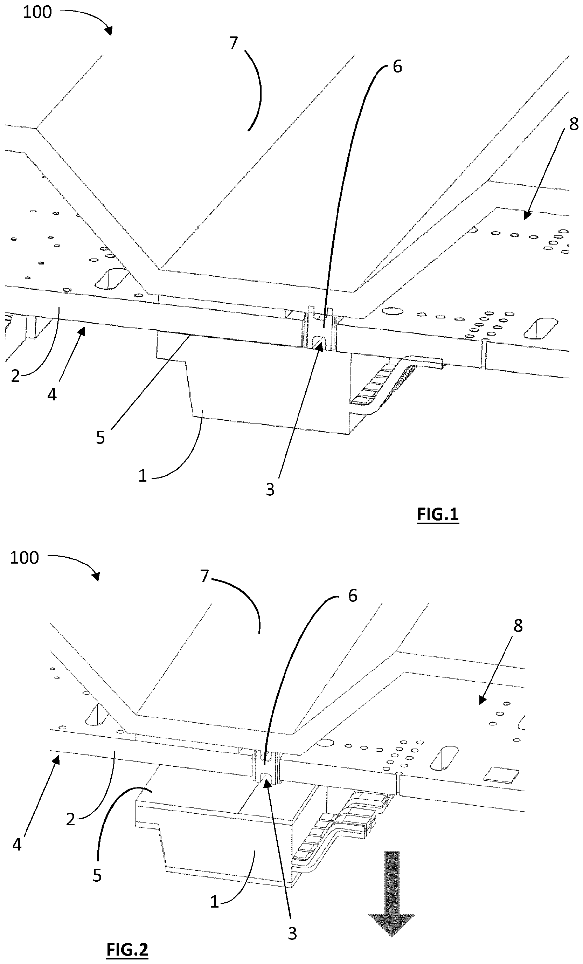

The present disclosure concerns a circuit board 100 having an electronic component 1 soldered onto a first surface 4 of a board 2 and an elastic component 6, mounted on the board 2, for pushing the electronic component 1 away from the first surface 4 of the board 2 when a temperature of the electronic component 1 exceeds a predetermined temperature threshold. Figures 1 and 2 represent a first exemplary embodiment of the circuit board 100, when the elastic component 6 is in a compressed condition and in a released condition, respectively.

The elastic component 6 is disposed within a hole provided through the board 2 and compressed by being sandwiched between a surface of the electronic component 1 and a surface of a compressing component 7 mounted onto a second surface 8 of the board 2, opposite to the first surface 4 (figure 1).

The elastic component 6 may be a component made of a compressible material, for example silicone, as represented in figures 1 to 3. In addition, the elastic component 6 made of a compressible material may have recesses for facilitating the compression.

The compressing component 7 is advantageously a heat sink having another function of cooling the electronic component 1.

The electronic component 1 is soldered to the board 2 for example with a solder paste. In that case, the predetermined temperature threshold corresponds to the melting point of the solder paste. For example, this melting point is around 230°C, when the solder paste is made of tin.

The electronic component 1 is connected to a circuit supported on the board 2, such as a printed circuit. The circuit board is for example a PCB (Printed Circuit Board).

The circuit board may have a plurality of N electronic components soldered onto the first surface 4 of the board 4 and N elastic components 6, respectively mounted within N holes 3 provided through the board 2, in a compressed condition.

The electronic components are for example power transistors, such as MOSFETs. The power transistors can be used as electronic switches, instead of mechanical switches, for applications with a high level safety requirement such as autonomous driving. For example, a bank of a plurality of power transistors, connected in parallel, can be used as a switch for interrupting a current in an electrical circuit. When a power transistor has failed and is stuck closed in a short-circuit state, and the other power transistors of the bank are switched off into an open state, the failed power transistor takes the full current and, consequently, its temperature increases. The circuit board 100 allows to avoid that such an abnormal situation leads to an thermal incident. The circuit board 100 is capable of interrupting the current in case of overheating, as explained below.

Indeed, when the temperature of the electronic component 1 of the circuit board 100 (for example one of a plurality of MOSFETs connected in parallel and stuck in a short-circuit condition) increases and reaches the melting point of the solder paste, the electronic component 1 is no longer stuck on the board 2 and, therefore, the elastic component 6 releases and pushes the electronic component 1 away from the first surface 4 of the board 2. As a result, the electronic component 1 disconnects and the current through the circuit is interrupted.

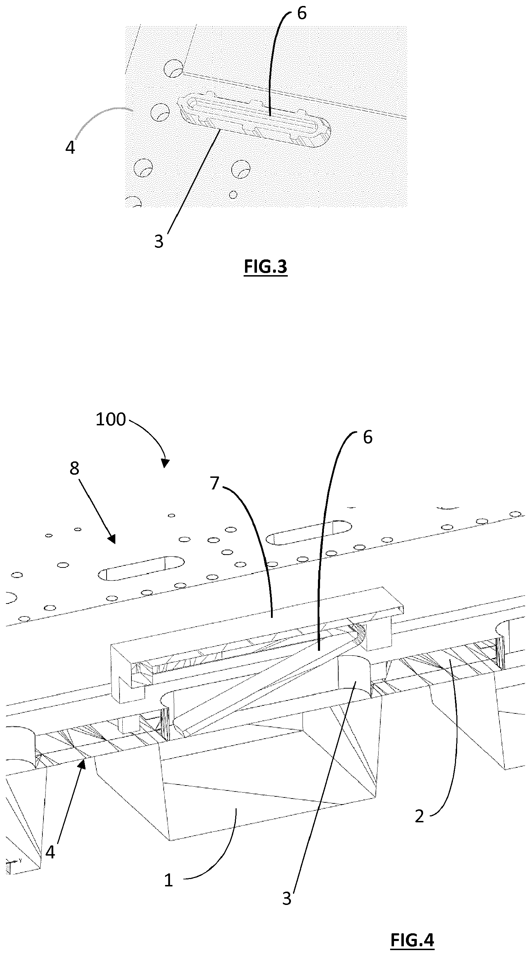

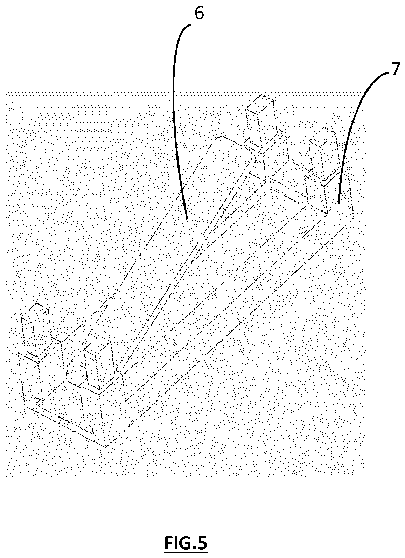

In a second exemplary embodiment, the elastic component 6 is a metallic leaf spring, as represented in figures 4 and 5. In this embodiment, the compressing component 7 is in the form of a bridge that extends over the hole 3 and receives the leaf spring 6.

Alternatively, the elastic component may be a coil spring, or have any other kind of shape.

The present disclosure also concerns a method for manufacturing the circuit board 100 having a first surface 4 on which one or more electronic components 1 are mounted. This method is useful when the electronic components are likely to suffer from an overheating, that may result in a thermal ignition.

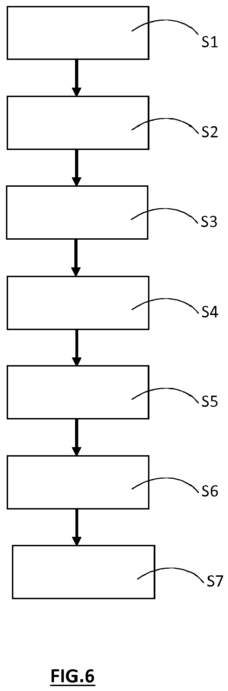

The method for manufacturing the circuit board 100 will now be described in more detail, with reference to figure 6. For the sake of clarity, it is assumed that the circuit board 100 has one electronic component 1 mounted thereon. However, the same disclosure applies to the manufacture of a circuit board having a plurality of electronic components mounted thereon.

The method comprises a first step S1 of providing a board 2 and a second step S2 of drilling a hole 3 through the board 2.

Then, in a third step S3, an amount of solder paste 5 is deposited on a first surface 4 of the board 2, next to the hole 3. The board 2 extends in a horizontal plane, and the solder paste 5 is deposited on the upper surface 4 of the board 2.

In a fourth step S4, the electronic component 1 is placed onto the first surface 4 of the board 2, so as to cover the deposit of solder paste 5 and the hole 3. More precisely, a surface of the electronic component 1 extends in a plane that includes the upper opening of the hole 3.

Then, the method has a fifth step S5 of soldering the electronic component 1 onto the first surface 4 of the board 2. For example, a process of wave soldering can be used.

After the step of soldering S5, an elastic component 6 is mounted on the board 2. This elastic component 6 has the function of pushing the electronic component 1 away from the first surface 4 of the board 2 when a temperature of the electronic component 1 exceeds a predetermined threshold. This predetermined temperature threshold corresponds to the melting point of the solder paste (around 230°C) when the solder paste is made of tin) used to solder the electronic component 1 to the board 2.

More precisely, the elastic component is placed in the through hole 3, in a sixth step S6.

Then, in a seventh step S7, the elastic component 6 is compressed within the through hole 3 by fixing a compressing component 7 to a second surface 8 of the board 2, opposite to the first surface 4. In this way, the elastic component 6 is enclosed in the hole 3 in a compressed condition. The elastic component 6 is sandwiched between the electronic component 1 and the compressing component 7 mounted on the second surface 8 of the board 2, opposite to the first surface.

The electronic component 1 is one element of a circuit supported by the board 2. When current flows in the circuit and the electronic component 1 fails and is stuck in a short-circuit condition, its temperature increases and reaches and/or exceeds the predetermined threshold (for example around 230°C). In this situation, the solder paste melts and the electronic component 1 is no longer strongly stuck onto the board 2. Therefore, the elastic component 6 releases and pushes the electronic component 1 away from the first surface 4 of the board 2. In this way, the electronic component 1 disconnects from the circuit and the current is thus interrupted. Consequently, the temperature of the electronic component decreases.

The present disclosure also concerns an electronic device incorporating the circuit board as previously described.

## Claims

1. A method for manufacturing a circuit board (100), said circuit including an electronic component (1), comprising the steps of
- placing (S4) the electronic component (1) onto a first surface (4) of a board (2),
- mounting (S6, S7) an elastic component (6) on the board (2), said elastic component (6) having the function of pushing the electronic component (1) away from the first surface (4) of the board (2) when a temperature of said electronic component (1) exceeds a predetermined threshold,
- soldering (S5) the electronic component (1) onto the first surface (4) of the board (2),
**characterized in that**
the step of mounting the elastic component (6) is performed after the step of soldering the electronic component (1).

2. The method according to claim 1, wherein the elastic component (6) is disposed within a hole (3) provided through the board (2).

3. The method according to any of claims 1 and 2, comprising a step of mounting a compressing component (7) on a second surface (8) of the board (2), opposite to the first surface (4), such that the elastic component (6) is sandwiched between the electronic component (1) and the compressing component (7).

4. The method according to any of claims 1 to 3, wherein a heat sink (7) is mounted onto a second surface (8) of the board (2), opposite to the first surface (4), and compresses the elastic component (6).

5. The method according to any of claims 1 to 4, wherein the elastic component (6) is one of the components of the group including a component made of silicone, a metallic leaf spring and a coil spring.

6. The method according to any of claims 1 to 5, wherein the electronic component (1) is soldered on the board (2) by wave soldering.

7. The method according to any of claims 1 to 6, wherein the electronic component (1) is a power transistor.

8. The method according to any of claims 1 to 7, wherein the predetermined temperature threshold corresponds to the melting point of a solder paste used to solder the electronic component onto the board.

9. A circuit board comprising an electronic component (1) soldered onto a first surface (4) of a board (2) and an elastic component (6), mounted on said board (2), for pushing the electronic component (1) away from the first surface (4) of the board (2) when a temperature of said electronic component (1) exceeds a predetermined temperature threshold, **characterized in that** the elastic component (6) is disposed within a hole (3) provided through the board (2) and compressed by being sandwiched between the electronic component (1) and a compressing component (7) mounted on a second surface (8) of the board (2), opposite to the first surface (4).

10. The circuit board according to claim 9, including a heat sink (7) that is mounted onto the second surface (8) of the board (2) and compresses the elastic component (6).

11. The circuit board according to any of claims 9 and 10, wherein the elastic component (6) is one of the components of the group including a component made of silicone, a metallic leaf spring and a coil spring.

12. The circuit board according to any of claims 9 to 11, wherein the electronic component (1) is a power transistor.

13. The circuit board according to any of claims 9 to 12, wherein the electronic component (1) is soldered to the board (2) with a solder paste (5), and the predetermined temperature threshold corresponds to the melting point of the solder paste (5).

14. The circuit board according to any of claims 9 to 13, comprising a plurality of N electronic components soldered onto the first surface (4) of the board (2) and N elastic components, respectively mounted within N holes provided through the board (2) in a compressed state.

15. An electronic device incorporating the circuit board according to any of claims 9 to 14.
